(19) Europäisches Patentamt
European Patent Office
Office européen des brevets

(11) **EP 2 054 874 B1**

(12) **EUROPEAN PATENT SPECIFICATION**

(45) Date of publication and mention
of the grant of the patent:
**11.07.2018 Bulletin 2018/28**

(51) Int Cl.:
***G10L 19/025*** *(2013.01)*

(21) Application number: **07800712.7**

(22) Date of filing: **17.08.2007**

(86) International application number:
**PCT/CN2007/002491**

(87) International publication number:
**WO 2008/022566 (28.02.2008 Gazette 2008/09)**

(54) **VARIABLE-RESOLUTION PROCESSING OF FRAME-BASED DATA**

VERARBEITUNG VON AUF RAHMEN BASIERENDEN DATEN MIT VARIABLER AUFLÖSUNG

TRAITEMENT À RÉSOLUTION VARIABLE DE DONNÉES FONDÉES SUR UNE TRAME

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **18.08.2006 US 822760 P**
**12.11.2006 US 558917**

(43) Date of publication of application:
**06.05.2009 Bulletin 2009/19**

(73) Proprietor: **Digital Rise Technology Co., Ltd.**
**Guangdong 510640 (CN)**

(72) Inventor: **YOU, Yuli**
**San Diego, CA 92130-4890 (US)**

(74) Representative: **Schaumburg und Partner**
**Patentanwälte mbB**
**Mauerkircherstraße 31**
**81679 München (DE)**

(56) References cited:
**WO-A-2006/030289**      **CN-A- 1 276 903**
**CN-A- 1 315 033**      **JP-A- 2005 268 912**
**US-A- 5 214 742**      **US-A1- 2002 048 364**
**US-A1- 2003 115 052**      **US-A1- 2005 204 238**
**US-B1- 6 226 608**

- **PRINCEN J P ET AL: "ANALYSIS/SYNTHESIS FILTER BANK DESIGN BASED ON TIME DOMAIN ALIASINGCANCELLATION", IEEE TRANSACTIONS ON ACOUSTICS, SPEECH AND SIGNAL PROCESSING, IEEE INC. NEW YORK, USA, vol. ASSP-34, no. 5, 1 October 1986 (1986-10-01), pages 1153-1161, XP000674042, ISSN: 0096-3518, DOI: 10.1109/TASSP.1986.1164954**

**Description**

This application claims the benefit of United States Provisional Patent Application Serial No. 60/822,760, filed on August 18, 2006, and titled "Variable-Resolution Filtering".

FIELD OF THE INVENTION

The present invention pertains to processing of audio signals.

BACKGROUND

Many conventional signal-processing techniques are frame-based. In such techniques, a stream of data is divided into discrete frames, and the data within each such frame ordinarily is processed in a fairly uniform manner. In one example, an input audio signal is divided into frames of equal length. Then, each frame is processed in a particular manner. A common processing parameter to be determined for each frame is block length or, equivalently, into how many equal-sized blocks should the frame be divided for processing purposes. Block length determines resolution in the original domain (e.g., time for an audio signal) and in the frequency (or other transform) domain. More specifically, shorter block lengths provide greater resolution in the original domain and lesser resolution in the frequency domain.

An audio signal often consists of quasi-stationary episodes, each including a number of tonal frequency components, which are interrupted by dramatic transients. Thus, an individual frame of such an audio signal often will include a few samples corresponding to a transient, but with the vast majority of the samples corresponding to quasi-stationary portions of the signal.

Because transients in audio signals can be as short as a few of samples, the block size that is used within a frame that has been detected as including a transient ideally should be just a few samples as well, thereby matching the filter's temporal resolution to the transient. Unfortunately, it usually is not practical to use different block sizes within the same frame. Making all of the blocks within a frame having a detected transient just a few samples wide would result in extremely poor frequency resolution within the frame and, therefore, is inappropriate for the rest of the samples in the frame; that is, such other samples, provided they are sufficiently far away from the transient, are quasi-stationary and therefore are better processed using high frequency resolution. This conflict conventionally has resulted in a compromise block size that is optimal neither for the transient samples nor for the quasi-stationary samples in the same frame.

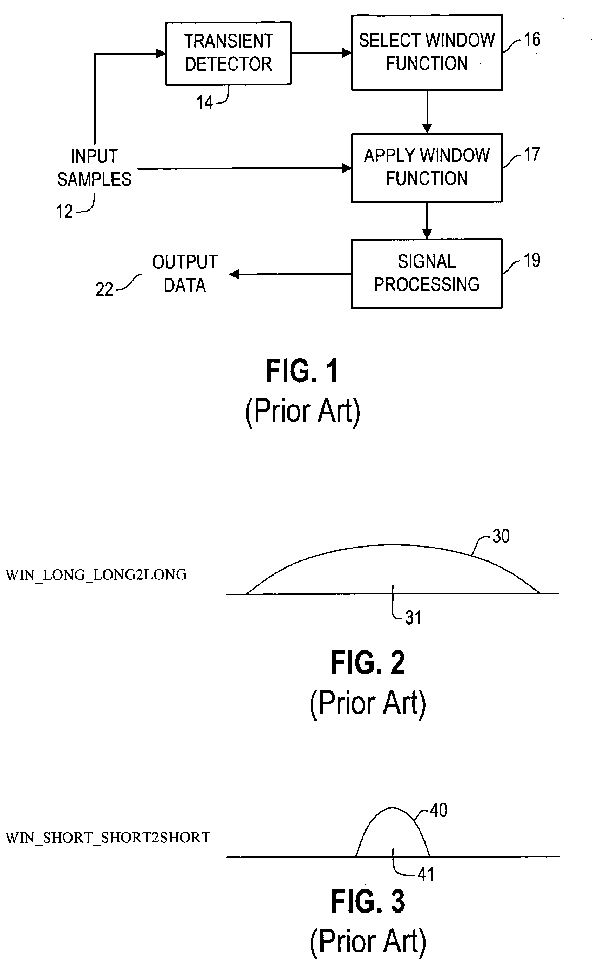

A block diagram of a conventional system for processing a frame of input samples 12 is illustrated in Figure 1. Initially, samples 12 are analyzed in transient detector 14 to determine whether the frame includes a transient.

Based on that detection, a window function is selected in module 16. In this regard, audio-coding algorithms often employ a filter bank that has different temporal-frequency resolutions. One commonly used filter bank is the MDCT (Modified Discrete Cosine Transform), having an impulse response that can be described by the following basis function:

$$h(k,n) = w(n)\sqrt{\frac{2}{M}}\cos\left[\frac{\pi}{M}\left(n + \frac{M+1}{2}\right)\left(k + \frac{1}{2}\right)\right],$$

where k = 0, 1, ..., M-1 ; n = 0, 1, ..., 2M-1 ; and w(n) is a window function of length 2M. See, e.g., H. S. Malvar, "Signal Processing with Lapped Transforms", Artech House, 1992 (referred to herein as Malvar).

In this case, the temporal-frequency resolution is determined by M, which sometimes is referred to herein as block size. A large M means low temporal resolution but high frequency resolution, while a small M means high temporal resolution and low frequency resolution.

For purposes of implementing module 16 (as shown in Figure 1), conventional coding algorithms typically use two block sizes. A large block size, implemented as a single block covering the entire frame, is used if no transient was detected in module 14. Alternatively, a small block size, implemented as a predetermined number of blocks covering the frame, is used if a transient was detected.

The principal window functions corresponding to these two block sizes are window function 30 (shown in Figure 2 and labeled as WIN_LONG_LONG2LONG) and window function 40 (shown in Figure 3 and labeled as WIN_SHORT_SHORT2SHORT), respectively. In order for the MDCT to be able to properly switch between these two principal window functions, the perfect reconstruction conditions (e.g., as described in Malvar) require the use of three transitional window functions, e.g.: window function 50 (shown in Figure 4 and labeled as WIN_LONG_LONG2SHORT), window function 60 (shown in Figure 5 and labeled as WIN_LONG_SHORT2LONG), and window function 70 (shown in Figure 6 and labeled as WIN_LONG_SHORT2SHORT). It is noted that all three such transitional window functions 50, 60 and 70 are for use with the long block (i.e., covering an entire frame).

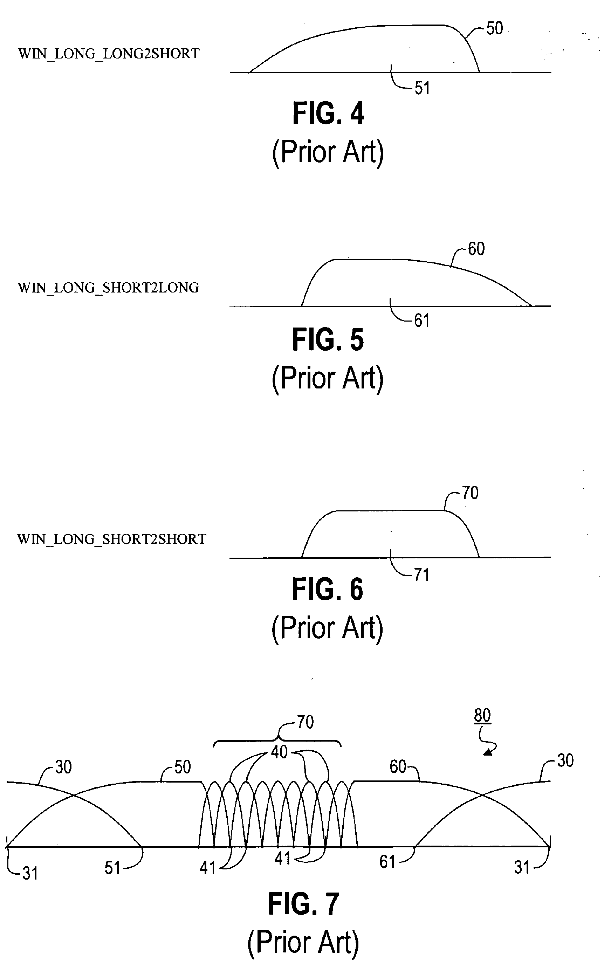

Thus, in the conventional techniques a frame is assigned a single long block (and corresponding long window 30, 50, 60 or 70) or a sequence of identical short blocks (and corresponding identical short windows 40). Because each block is longer than the block-to-block spacing, the result is an overlapping sequence of long and short windows, such as the sequence 80 of window functions shown in Figure 7, with each window covering the M new samples of the current block together with M samples in the previous block. For reference purposes, the middle of each block corresponding to a window function 30, 40, 50, 60 or 70 is designated as 31, 41, 51, 61 or 71, respectively, in the drawings.

It is noted that such conventional techniques select the window function for a frame that does not include a transient, based not only on the detection made by module 14 for such current frame, but also based on similar detections made for the previous and subsequent frames. That is, window functions 50, 60 and 70 are used as transition window functions between transient frames and non-transient frames.

Referring back to Figure 1, in module 17 the window function selected in module 16 is then applied (multiple times for a transient frame) to the input samples 12 for the current frame. That is, for each block the sample values are multiplied by the window function values corresponding to that block in order to obtain a set of weighted values.

Those weighted values are then processed in module 19 using the selected window function to provide the output values 22. The specific type of processing performed in module 19 can vary depending upon the desired application. For example, with respect to an audio signal, the processing might involve analysis, coding, and/or enhancement.

From the United States patent US 5,214,742 a system and method for processing frame-based data is known, including assignment of different window functions to different equal-sized frames. Moreover, from US 6,226,608 B1 partitioning a frame having a transient into equal-sized blocks and applying different window functions to these blocks is known.

The International Patent Application published under the publication number WO 2006/030289 A1 and US 2003/115052 A1, respectively, teach a method according to the precharacterizing part of claim 1 and a system according to the precharacterizing part of claim 4.

The present invention pertains to a method of processing frame-based data according to claim 1 and a system for processing frame-based data according to claim 4. Advantageous preferred embodiments are claimed in the dependent claims 2, 3, 5 and 6.


SUMMARY OF THE INVENTION

The present invention addresses this problem and others by, *inter alia,* using multiple different window functions within a frame that has been detected as including a transient. The present invention provides at least two levels of resolution within a single data frame having a detected transient.

Such multiple resolutions are provided without changing the block size within the frame.

As a result, e.g., a higher resolution is used in the vicinity of the transient and a lower resolution used in other portions of the frame. It is noted that unqualified use of the term "resolution" herein refers to resolution in the original (e.g., temporal) domain. Because resolution in the frequency (or other transform) domain varies inversely with a resolution in the original domain, in these embodiments of the invention a higher frequency (or other transform-domain) resolution is provided for portions of the frame that do not include the transient. Moreover, by holding block size constant, the foregoing advantages generally can be achieved without complicating the processing structure.

Thus, in one respect, the invention is as set forth in independent claim 1, directed to processing frame-based data, in which a frame of data, an indication that a transient occurs within the frame, and a location of the transient within the frame are obtained. Based on the indication of the transient, a block size is set for the frame, thereby effectively defining a plurality of equal-sized blocks within the frame. In addition, different window functions are selected for different ones of the plurality of equal-sized blocks based on the location of the transient, and the frame of data is processed by applying the selected window functions.

The blocks overlap each other, and each window function also overlaps each adjacent window function, preferably in a manner so as to satisfy the perfect reconstruction conditions. The foregoing overlap properties apply to adjacent blocks and window functions within a frame, as well as to adjacent blocks and window functions in adjacent frames.

In any case, the window functions are selected to provide higher resolution within an identified one of the equal-sized blocks that includes the transient. Moreover, this is achieved by using, within the identified block a transient window function that is narrower than others of the window functions by zeroing samples within the block but outside of the transient window functions. In other words, while the width of the block remains constant across the frame, the widths of the window functions within those blocks are varied, if desired, to achieve the desired resolution trade-off (e.g., temporal/frequency) for each block of the frame.

In this regard, the width of a window function can be defined in a number of different ways. For example, it can be defined as the length of the non-zero portion of the window function, the length of that portion of the window function above a specified threshold, or the length of that portion of the window function that includes some specified percentage of the content (e.g., energy) of the window function.

Accordingly, the width of a window function can be varied by compressing or expanding a standard shape and then zeroing any samples within the block but not included within the compressed shape. Alternatively, the width can be varied by using different shapes, some with more of their energy concentrated in a smaller segment.

The foregoing summary is intended merely to provide a brief description of the certain aspects of the invention. A more complete understanding of the invention can be obtained by referring to the claims and the following detailed description of the preferred embodiments in connection with the accompanying figures.

BRIEF DESCRIPTION OF THE DRAWINGS

Figure 1 is a block diagram of a conventional system for modifying temporal resolution within a data frame based on the existence of transients.

Figure 2 illustrates a conventional window function for a frame having a long block size, when sandwiched between two frames also having a long block size.

Figure 3 illustrates a conventional window function for a frame having a short block size.

Figure 4 illustrates a conventional transitional window function for a frame having a long block size, when preceded by a frame having a long block size and followed by a frame having a short block size.

Figure 5 illustrates a conventional transitional window function for a frame having a long block size, when preceded by a frame having a short block size and followed by a frame having a long block size.

Figure 6 illustrates a conventional transitional window function for a frame having a long block size, when preceded by a frame having a short block size and followed by a frame having a short block size.

Figure 7 illustrates an exemplary conventional sequence of window functions, in which a frame that includes a transient is bordered on each side by two frames that do not include a transient.

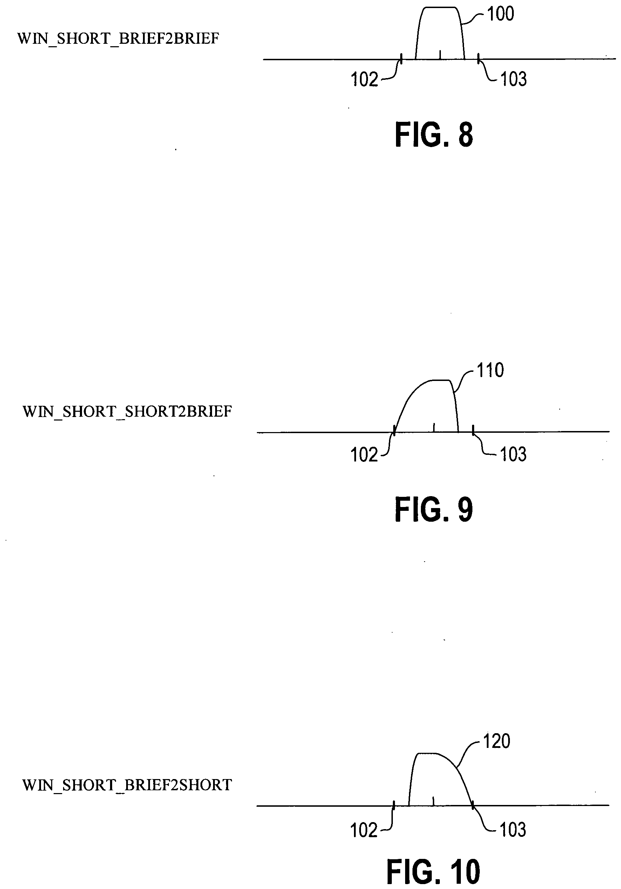

Figure 8 illustrates a brief window function WIN_SHORT_BRIEF2BRIEF according to a representative embodiment of the present invention.

Figure 9 illustrates a transitional window function WIN_SHORT_SHORT2BRIEF according to a representative embodiment of the present invention.

Figure 10 illustrates a transitional window function WIN_SHORT_BRIEF2SHORT according to a representative embodiment of the present invention.

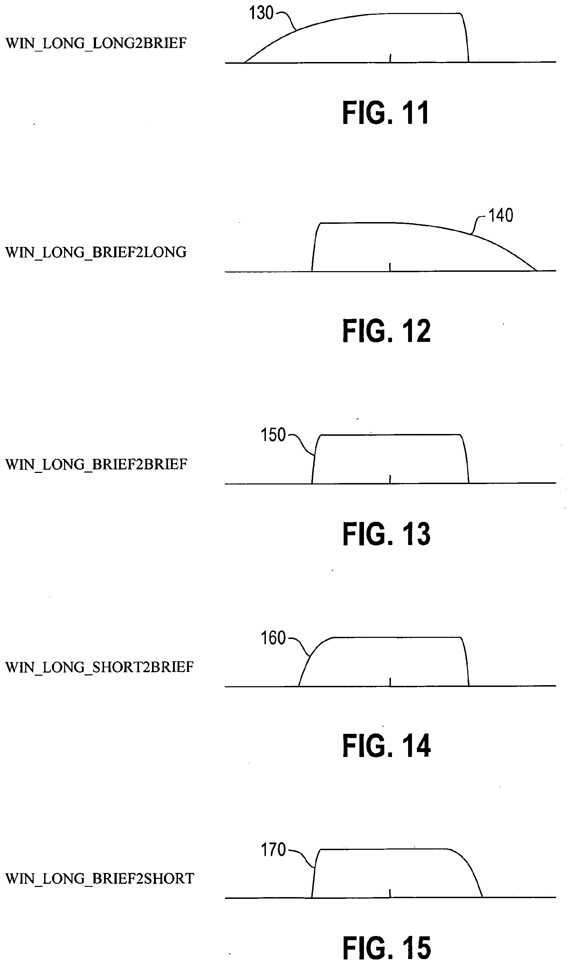

Figure 11 illustrates a transitional window function WIN_LONG_LONG2BRIEF according to a representative embodiment of the present invention.

Figure 12 illustrates a transitional window function WIN_LONG_BRIEF2LONG according to a representative embodiment of the present invention.

Figure 13 illustrates a transitional window function WIN_LONG_BRIEF2BRIEF according to a representative embodiment of the present invention.

Figure 14 illustrates a transitional window function WIN_LONG_SHORT2BRIEF according to a representative embodiment of the present invention.

Figure 15 illustrates a transitional window function WIN_LONG_BRIEF2SHORT according to a representative embodiment of the present invention.

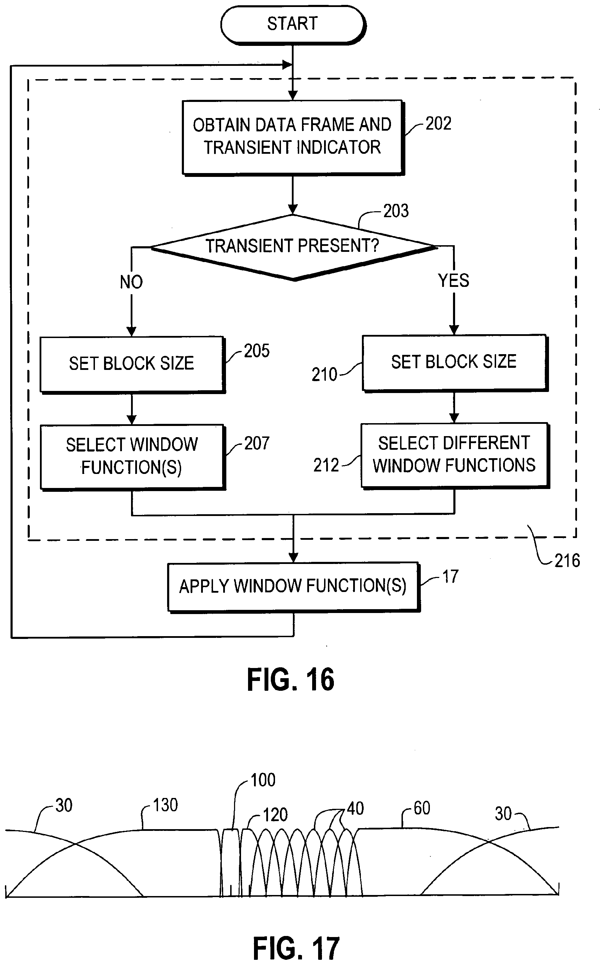

Figure 16 is a flow diagram illustrating a technique for selecting window functions according to a representative embodiment of the present invention.

Figure 17 illustrates a first exemplary window function sequence according to the present invention.

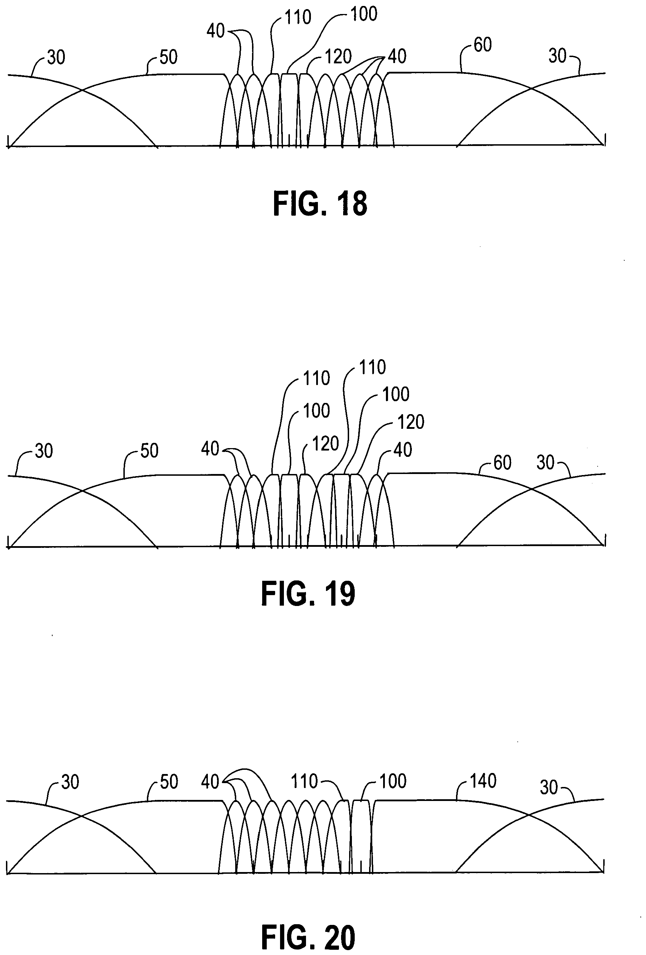

Figure 18 is illustrates a second exemplary window function sequence according to the present invention.

Figure 19 illustrates a third exemplary window function sequence according to the present invention.

Figure 20 illustrates a fourth exemplary window function sequence according to the present invention.

DESCRIPTION OF THE PREFERRED EMBODIMENT(S)

The present invention is directed primarily to improvements in the window function selection component 16 of the conventional systems. One feature of the present invention is the introduction of a new "brief window function", e.g., window function 100 as shown in Figure 8. This window function 100, labeled as WIN_SHORT_BRIEF2BRIEF, is intended to be used within a short block, similar to conventional window function WIN_SHORT_SHORT2SHORT 40. In fact, as described in more detail below, in the preferred embodiments of the invention window function WIN_SHORT_BRIEF2BRIEF 100 is intended for use within the same frame as window function WIN_SHORT_SHORT2SHORT 40.

However, unlike conventional window functions, brief window function 100 uses for signal shaping only a central portion of the overall length of the block (having endpoints 102 and 103 in Figure 8) it occupies, employing a number of leading and trailing zero weights, in order to improve its temporal resolution. For example, where the short block length = 256 samples, the brief window function 100 preferably is nonzero within the central 160 samples (where it also is symmetric), with the first 16 and last 16 of such samples overlapping the respective transition window functions that are adjacent to it, and with zero weights for the first 48 samples and the last 48 samples of the window.

This brief window function 100 is only used where the transient samples within an audio frame have been detected (e.g., in the blocks that include transient samples), while the regular short window function (e.g., conventional window function 40), or one of the new transitional functions provided by the present invention, is applied to the quasi-stationary samples in the remainder of the frame. This allows for the following possibilities, as compared with conventional techniques:

- A significantly larger block size can be used, in which case the frequency resolution for the quasi-stationary samples is improved while the temporal resolution around the transient samples is left unchanged.
- The block size can be left unchanged, in which case the frequency resolution for the quasi-stationary samples is unchanged while the temporal resolution around the transient samples is improved.
- A somewhat larger block size can be used, in which case the frequency resolution for quasi-stationary samples is improved somewhat while the temporal resolution around the transient samples also is improved somewhat.

With any of the above choices, the compromise solution addressing the conflicting temporal-frequency resolution requirements is improved.

In order to facilitate the use of window function 100 in connection with the other two principal window functions, namely WIN_ LONG_LONG2LONG 30 and WIN_SHORT_SHORT2SHORT 40 (e.g., in order to satisfy the perfect reconstruction conditions), additional transitional window functions preferably are introduced. Examples of such transitional window functions follow. Initially, however, it is noted that the present disclosure generally uses the nomenclature: *WTN_BlockLength_PriorWF2SubsWF,* where *BlockLength* indicates the length of the block occupied by the present window function (e.g., long or short), *PriorWF* identifies the type of window function in the immediately preceding block (e.g., long, short or brief), and *SubsWF* identifies the type of window function in the immediately subsequent block (e.g., long, short or brief).

Transitional window function 110 (shown in Figure 9 and labeled as WIN_SHORT_SHORT2BRIEF) is for use within a short block immediately preceding another short block that includes the transient. That is, it immediately precedes window function WIN_SHORT_BRIEF2BRIEF 100.

Window function 120 (shown in Figure 10 and labeled as WIN_SHORT_BRIEF2SHORT) is for use within a short block immediately following another short block that includes the transient. That is, it immediately follows window function WIN_SHORT_BRIEF2BRIEF 100.

Window function 130 (shown in Figure 11 and labeled as WIN_LONG_LONG2BRIEF) is for use within a long block immediately preceding a short block that includes the transient. That is, it covers a frame immediately preceding a subsequent frame that includes a transient, the transient being within the very first block of the subsequent frame.

Window function 140 (shown in Figure 12 and labeled as WIN_LONG_BRIEF2LONG) is for use within a long block immediately following a short block that includes the transient. That is, it covers a frame immediately following a preceding frame that includes a transient, the transient being within the very last block of the preceding frame.

Window function 150 (shown in Figure 13 and labeled as WIN_LONG_BRIEF2BRIEF) is for use within a long block sandwiched between two short blocks that include transients. That is, it covers a frame between two frames that include transients, the transient in the preceding frame being within its very last block and the transient in the subsequent frame being within its very first block.

Window function 160 (shown in Figure 14 and labeled as WIN_LONG_SHORT2BRIEF) is for use within a long block covering a frame between two frames that include transients, the transient in the preceding frame being somewhere other than its very last block and the transient in the subsequent frame being within its very first block.

Window function 170 (shown in Figure 15 and labeled as WIN_LONG_BRIEF2SHORT) is for use within a long block covering a frame between two frames that include transients, the transient in the preceding frame being within its very last block and the transient in the subsequent frame being somewhere other than its very first block.

In each case, the window function preferably is designed so that it overlaps the adjacent window function on each side in a manner so as to satisfy the perfect reconstruction conditions. Specific examples of window functions that may be used are given below.

Figure 16 is a flow diagram illustrating a technique for selecting window functions according to a representative embodiment of the present invention. Generally speaking, the entire process illustrated in Figure 16 will be automated (e.g., implemented in software, firmware, dedicated hardware or any combination thereof).

Initially, in step 202 a frame of data is obtained. In this regard, a variety of different types of data may be processed according to the present invention. Throughout this disclosure, it often is assumed that the data correspond to an audio signal. However, this should not be taken as limiting and the obtained data instead may be representative of any other physical phenomena, such as an image signal, a video signal, or a signal representative of heat, pressure, radiation, motion, distance, any biological function, weather and/or any geological phenomenon.

Also, it should be noted that the data frame may have been defined by the source of the data (e.g., as where date are being received over a communication channel). Alternatively, e.g., the data may be received in a continuous stream and segmented (e.g., internally) into frames for processing purposes. In any event, the present processing is particularly (although not exclusively) applicable to data which are separated into individual frames. As indicated above, frame-based processing allows individual portions of the overall data stream to be processed in a uniform manner in some particular respects.

Each frame has a uniform block size. In this regard, the block preferably is defined as the basic signal- processing unit for the frame. For example, in the event that the data within the frame are to be transformed (e.g., in the signal-processing module 19) from the original domain (e.g., the time domain in the event of an audio signal) to the frequency domain (e.g., using a Discrete Cosine Transform or a Fast Fourier Transform), or to any other transform domain defined by a set of orthogonal functions, the transformation and any subsequent processing within the transform domain preferably are performed separately for each block.

Thus, a frame is covered by a single block or, alternatively, by a plurality of equal-sized blocks. As with the conventional techniques, there are only two block sizes: a large block size that covers an entire frame and a small block size resulting in a plurality of contiguous blocks that are uniformly distributed throughout the frame.

Moreover, in order to address boundary problems that otherwise would occur, as with the conventional techniques, the blocks of the present invention preferably overlap each other (e.g., in a manner satisfying the perfect reconstruction conditions). Conceptually, each block can be thought of as including a number of core samples that subsequently are to be processed (e.g., in module 19) and a number of boundary samples adjacent to such core samples. In the preferred embodiments, the core samples are new samples in the sequence and the boundary samples are historic samples from the preceding block. The frames, on the other hand, preferably are contiguous and non-overlapping. As a result, the block at the beginning of a frame overlaps the preceding frame. For frames covered by a single block, that single block overlaps the entire preceding frame.

In addition to obtaining the data frame itself, step 202 also obtains a transient indicator (e.g., from transient detector 14). In the preferred embodiment, the obtained transient indicator indicates whether a transient is present in the current frame and, if so, where in the frame it is. If more than one transient has been detected in the current frame, then the location of each such transient preferably is obtained (e.g., identified by and then received from transient detector 14). In order to simplify the explanation, the present disclosure sometimes assumes, without loss of generality, that only a single transient (if any) is detected in each frame.

The actual detection of transients can be performed using, e.g., any existing techniques. Ordinarily, a transient will manifest itself as a spike in highfrequency components over a very short period of time and, therefore, can be detected on this basis. In any event, a threshold level often will be specified, below which signal activity will not be deemed a transient.

Referring back to Figure 16, in step 203 a determination is made as to whether a transient exists in the present frame. Preferably, this determination is straightforward based on the information provided by transient detector 14. If a transient is not present, then processing proceeds to step 205. If one is, then processing proceeds to step 210.

In step 205, the block size is set based on the determination that the present frame does not include a transient. A single block is used to cover the entire frame in such a case. More preferably, the block includes all of the samples in the current frame as the core samples, as well as part or all of the samples from the preceding frame(s). An exemplary block size is 2,048 samples, i.e.,

1,024 core samples (frame size also being 1,024 samples) and 1,024 samples from the preceding frame.

Next, in step 207 the window function is selected for the current frame (assuming a single block is to cover the entire frame). In the preferred embodiments, this step involves evaluating the immediately preceding and immediately subsequent frames/blocks. Due to the increased number of window functions, as compared with conventional techniques, the determination of the appropriate window sequence typically is somewhat more complicated, but the underlying principle is relatively straightforward. Specifically, a long window function is selected, with the specific shape depending on the existence and location of any transient in the previous and next frame. The specific selection preferably is made as follows:

| Previous Frame | Current Frame | Next Frame |
|---|---|---|
| No Transient | WIN_LONG_LONG2LONG 30 | No Transient |
| | WIN_LONG_LONG2SHORT 50 | Transient, but not in the first block |
| | WIN_LONG_LONG2BRIEF 130 | Transient in the first block |
| Transient, but not in the last MDCT block | WIN_LONG_SHORT2LONG 60 | No Transient |
| | WIN_LONG_SHORT2SHORT 70 | Transient, but not in the first block |
| | WIN_LONG_ SHORT2BRIEF 160 | Transient in the first block |
| Transient in the last MDCT block | WIN_LONG_BRIEF2LONG 140 | No Transient |
| | WIN_LONG_BRIEF2SHORT 170 | Transient, but not in the first block |
| | WIN_LONG_BRIEF2BRIEF 150 | Transient in the first block |

Once the appropriate window function has been selected in step 207, it is applied in step 17 (e.g., as discussed above).

On the other hand, if it were determined in step 203 that a transient exists in the current frame, then processing would have proceeded to step 210, in which the block size is set to "small". One example, for a frame size of 1,024 samples, is a block size of 256 samples, i.e., 128 core samples and 128 samples overlapping with the preceding block (so that the frame is covered by 8 blocks). [68] In any event, once the block size has been established, processing proceeds to step 212, in which different window functions are selected for the different blocks within the current frame. Because it is known that the current frame includes at least one transient, the WIN_SHORT_BRIEF2BRIEF window function 100 will be used at least once (at the identified location(s)). More preferably, a sequence of brief and short window functions are selected for the short blocks of the current frame according to the following principles:

- WIN_SHORT_BRIEF2BRIEF is applied to samples in the block where a transient occurs, in order to improve the temporal resolution of the block.
- The window function for the window that is immediately before the window that includes the transient has a designation of the form "... 2BRIEF".
- The window function for the window that is immediately after the window that includes the transient has a designation of the form "..._BRIEF2...".

Consequently, any of the following combinations of window functions is permissible:

| Pre-Transient | Transient | Post-Transient |
|---|---|---|
| WIN_LONG_LONG2BRIEF | | WIN_LONG_BRIEF2LONG |
| WIN_LONG_SHORT2BRIEF | | WIN_LONG_BRIEF2SHORT |
| WIN_LONG_BRIEF2BRIEF | WIN_SHORT_BRIEF2BRIEF | WIN_LONG_BRIEF2BRIEF |
| WIN_SHORT_SHORT2BRIEF | | WIN_SHORT_BRIEF2SHORT |
| WIN_SHORT_BRIEF2BRIEF | | WIN_SHORT_BRIEF2BRIEF |

A specific procedure, written in C, for placing window functions within a frame is set forth in the section of this disclosure titled, "Window Function Selection Routine". Generally speaking, however, the pre-transient transitional window function is selected from the left column in the above table based on its own block length (long or short) and the nature of the window function immediately preceding it (long, short or brief). Similarly, the post-transient transitional window function is selected from the right column in the above table based on its own block length (long or short) and the nature of the window function immediately following it (long, short or brief). Each block within the current frame that is not (i) pre-transient (a block immediately preceding a transient block), (ii) transient (a block that includes a transient), (iii) post-transient (a block that immediately follows a transient block), (iv) the first block of the frame, or (v) the last block of the frame preferably is assigned a window function of WIN_SHORT_SHORT2SHORT 40. The first block in the current frame (assuming it is not a pre-transient, transient or post-transient block) preferably is assigned a window function of WIN_SHORT_*PriorWF*2SHORT, and the last block in the current frame (assuming it is not a pre-transient, transient or post-transient block) preferably is assigned a window function of WIN_SHORT_SHORT2*SubsWF.*

Upon completion of step 212, processing proceeds to step 17 to apply the selected window functions. Upon completion of step 17, processing returns to step 202 to process the next frame.

It should be understood that the flow diagram shown in Figure 16 primarily is conceptual in nature. In fact, as indicated above, the selection of window function(s) for one frame typically will be affected by the presence and location of transients in adjacent frames. Accordingly, the selection of window function(s) for one frame may be performed concurrently with the selection of window function(s) for one or more other frames. At the very least, the selection for a current frame preferably is in anticipation of the window function that will be applied to a subsequent frame.

It is noted that the portion 216 of the flow diagram shown in Figure 16 can used in place of corresponding processing performed in conventional window-function selection module 16 (in Figure 1). As a result, the techniques of the present invention typically can be easily incorporated as an improvement to conventional systems.

One application in which the present invention may be used is for audio coding/decoding. Within such a system, the encoder typically indicates to the decoder the window function that it used to encode the current frame so that the decoder can use the same window function to decode the frame. With conventional techniques, only one window function index generally needs to be transmitted to the decoder to accomplish this purpose because:

- For a frame without a detected transient, only one of the long window functions is used, and hence needs to be indicated to the decoder.
- For a frame that includes one or more transients, all the window functions within the frame are the same, namely, WIN_SHORT_SHORT2SHORT 40. Such a frame 70 (which is sandwiched between two frames without a detected transient) is illustrated in Figure 7.

The statement above also is true for the technique of the present invention. That is, only one window function index needs to be transmitted to the decoder in order for the decoder to use the same window functions as the encoder to decode the frame. This is because:

- For a frame without a detected transient, the present technique also needs only to indicate to the decoder which one of the long window functions is used.
- For a frame with a detected transient, the encoder only needs to indicate to the decoder if there is a transient in the first block of the current frame and if there is a transient in the first block of the next frame; then, the sequence of window functions for the whole frame can be determined using the procedures described herein. Because the WIN_SHORT_BRIEF2BRIEF window function 100 is used for a block with a transient in the preferred embodiments, the following nomenclature may be used to convey this message: WIN_SHORT_*CurrentSubs*, where *Current* (SHORT=no, BRIEF=yes) identifies if there is transient in the first block of current frame, and *Subs* (SHORT=no, BRIEF=yes) identifies if there is transient in the first block of the subsequent frame. For example, WIN_SHORT_BRIEF2BRIEF indicates that there is transient in the first block of the current frame and in the first block of the subsequent frame, and WIN_SHORT_BRIEF2SHORT indicates that there is transient in the first block of the current frame but not in the first block of the subsequent frame.

Figures 17-20 illustrate exemplary window function sequences according to the present invention. In each such sequence, a frame having at least one transient (as indicated by WIN_SHORT_BRIEF2BRIEF window function 100) is surrounded by two frames on each side that do not include a transient. However, these examples are not to be taken as limiting; consecutive frames, each having at least one transient, also are allowed.

Exemplary Implementation

One widely used window function is the following sine function:

$$w(n) = \sin\left[\frac{\pi}{2M}\left(n + \frac{1}{2}\right)\right].$$

If M=L for long window function, M=S for short window function, and M=B for brief window function, where L>S>B, then the following window functions can be defined:

WIN_LONG_LONG2LONG:

$$w(n) = \sin\left[\frac{\pi}{2L}\left(n + \frac{1}{2}\right)\right], \quad 0 \le n < 2L.$$

WIN_LONG_LONG2SHORT:

$$w(n) = \begin{cases} \sin\left[\dfrac{\pi}{2L}\left(n + \dfrac{1}{2}\right)\right] & , & 0 \le n < L; \\[2mm] 1 & , & L \le n < \dfrac{3L - S}{2}; \\[2mm] \sin\left[\dfrac{\pi}{2S}\left(\left(n - \dfrac{3L - 3S}{2}\right) + \dfrac{1}{2}\right)\right] & , & \dfrac{3L - S}{2} \le n < \dfrac{3L + S}{2}; \\[2mm] 0 & , & \dfrac{3L + S}{2} \le n < 2L. \end{cases}$$

WIN_LONG_SHORT2LONG:

$$w(n) = \begin{cases} 0 & , & 0 \le n < \dfrac{L - S}{2}; \\[2mm] \sin\left[\dfrac{\pi}{2S}\left(\left(n - \dfrac{L - S}{2}\right) + \dfrac{1}{2}\right)\right] & , & \dfrac{L - S}{2} \le n < \dfrac{L + S}{2}; \\[2mm] 1 & , & \dfrac{L + S}{2} \le n < L; \\[2mm] \sin\left[\dfrac{\pi}{2L}\left(n + \dfrac{1}{2}\right)\right] & , & L \le n < 2L. \end{cases}$$

WIN_LONG_SHORT2SHORT:

$$w(n) = \begin{cases} 0 & , & 0 \le n < \dfrac{L - S}{2}; \\[2mm] \sin\left[\dfrac{\pi}{2S}\left(\left(n - \dfrac{L - S}{2}\right) + \dfrac{1}{2}\right)\right] & , & \dfrac{L - S}{2} \le n < \dfrac{L + S}{2}; \\[2mm] 1 & , & \dfrac{L + S}{2} \le n < \dfrac{3L - S}{2}; \\[2mm] \sin\left[\dfrac{\pi}{2S}\left(\left(n - \dfrac{3L - 3S}{2}\right) + \dfrac{1}{2}\right)\right] & , & \dfrac{3L - S}{2} \le n < \dfrac{3L + S}{2}; \\[2mm] 0 & , & \dfrac{3L + S}{2} \le n < 2L. \end{cases}$$

WIN_SHORT_SHORT2SHORT:

$$w(n) = \sin\left[\frac{\pi}{2S}\left(n + \frac{1}{2}\right)\right], \quad 0 \le n < 2S.$$

WIN_SHORT_BRIEF2BRIEF:

$$
w(n) = \begin{cases}
0 & , \quad 0 \le n < \dfrac{S-B}{2}; \\[2mm]
\sin\left[\dfrac{\pi}{2B}\left(\left(n - \dfrac{S-B}{2}\right) + \dfrac{1}{2}\right)\right] & , \quad \dfrac{S-B}{2} \le n < \dfrac{S+B}{2}; \\[2mm]
1 & , \quad \dfrac{S+B}{2} \le n < \dfrac{3S-B}{2}; \\[2mm]
\sin\left[\dfrac{\pi}{2B}\left(\left(n - \dfrac{3S-3B}{2}\right) + \dfrac{1}{2}\right)\right] & , \quad \dfrac{3S-B}{2} \le n < \dfrac{3S+B}{2}; \\[2mm]
0 & , \quad \dfrac{3S+B}{2} \le n < 2S.
\end{cases}
$$

WIN_LONG_LONG2BRIEF:

$$
w_1(n) = \begin{cases}
\sin\left[\dfrac{\pi}{2L}\left(n + \dfrac{1}{2}\right)\right] & , \quad 0 \le n < L; \\[2mm]
1 & , \quad L \le n < \dfrac{3L-B}{2}; \\[2mm]
\sin\left[\dfrac{\pi}{2B}\left(\left(n - \dfrac{3L-3B}{2}\right) + \dfrac{1}{2}\right)\right] & , \quad \dfrac{3L-B}{2} \le n < \dfrac{3L+B}{2}; \\[2mm]
0 & , \quad \dfrac{3L+B}{2} \le n < 2L.
\end{cases}
$$

WIN_LONG_BRIEF2LONG:

$$
w_1(n) = \begin{cases}
0 & , \quad 0 \le n < \dfrac{L-B}{2}; \\[2mm]
\sin\left[\dfrac{\pi}{2B}\left(\left(n - \dfrac{L-B}{2}\right) + \dfrac{1}{2}\right)\right] & , \quad \dfrac{L-B}{2} \le n < \dfrac{L+B}{2}; \\[2mm]
1 & , \quad \dfrac{L+B}{2} \le n < L; \\[2mm]
\sin\left[\dfrac{\pi}{2L}\left(n + \dfrac{1}{2}\right)\right] & , \quad L \le n < 2L.
\end{cases}
$$

WIN_LONG_BRIEF2BRIEF:

$$w(n) = \begin{cases} 0 & , & 0 \leq n < \dfrac{L-B}{2}; \\[2ex] \sin\left[\dfrac{\pi}{2B}\left(\left(n - \dfrac{L-B}{2}\right) + \dfrac{1}{2}\right)\right] & , & \dfrac{L-B}{2} \leq n < \dfrac{L+B}{2}; \\[2ex] 1 & , & \dfrac{L+B}{2} \leq n < \dfrac{3L-B}{2}; \\[2ex] \sin\left[\dfrac{\pi}{2B}\left(\left(n - \dfrac{3L-3B}{2}\right) + \dfrac{1}{2}\right)\right] & , & \dfrac{3L-B}{2} \leq n < \dfrac{3L+B}{2}; \\[2ex] 0 & , & \dfrac{3L+B}{2} \leq n < 2L. \end{cases}$$

WIN_LONG_SHORT2BRIEF:

$$w(n) = \begin{cases} 0 & , & 0 \leq n < \dfrac{L-S}{2}; \\[2ex] \sin\left[\dfrac{\pi}{2S}\left(\left(n - \dfrac{L-S}{2}\right) + \dfrac{1}{2}\right)\right] & , & \dfrac{L-S}{2} \leq n < \dfrac{L+S}{2}; \\[2ex] 1 & , & \dfrac{L+S}{2} \leq n < \dfrac{3L-B}{2}; \\[2ex] \sin\left[\dfrac{\pi}{2B}\left(\left(n - \dfrac{3L-3B}{2}\right) + \dfrac{1}{2}\right)\right] & , & \dfrac{3L-B}{2} \leq n < \dfrac{3L+B}{2}; \\[2ex] 0 & , & \dfrac{3L+B}{2} \leq n < 2L. \end{cases}$$

WIN_LONG_BRIEF2SHORT:

$$w(n) = \begin{cases} 0 & , & 0 \leq n < \dfrac{L-B}{2}; \\[2ex] \sin\left[\dfrac{\pi}{2B}\left(\left(n - \dfrac{L-B}{2}\right) + \dfrac{1}{2}\right)\right] & , & \dfrac{L-B}{2} \leq n < \dfrac{L+B}{2}; \\[2ex] 1 & , & \dfrac{L+B}{2} \leq n < \dfrac{3L-S}{2}; \\[2ex] \sin\left[\dfrac{\pi}{2S}\left(\left(n - \dfrac{3L-3S}{2}\right) + \dfrac{1}{2}\right)\right] & , & \dfrac{3L-S}{2} \leq n < \dfrac{3L+S}{2}; \\[2ex] 0 & , & \dfrac{3L+S}{2} \leq n < 2L. \end{cases}$$

WIN_SHORT_SHORT2BRIEF:

$$w(n) = \begin{cases} \sin\left[\dfrac{\pi}{2S}\left(n+\dfrac{1}{2}\right)\right] & , & 0 \le n < S; \\[2ex] 1 & , & S \le n < \dfrac{3S-B}{2}; \\[2ex] \sin\left[\dfrac{\pi}{2B}\left(\left(n-\dfrac{3S-3B}{2}\right)+\dfrac{1}{2}\right)\right] & , & \dfrac{3S-B}{2} \le n < \dfrac{3S+B}{2}; \\[2ex] 0 & , & \dfrac{3S+B}{2} \le n < 2S. \end{cases}$$

WIN_SHORT_BRIEF2SHORT:

$$w(n) = \begin{cases} 0 & , & 0 \le n < \dfrac{S-B}{2}; \\[2ex] \sin\left[\dfrac{\pi}{2B}\left(\left(n-\dfrac{S-B}{2}\right)+\dfrac{1}{2}\right)\right] & , & \dfrac{S-B}{2} \le n < \dfrac{S+B}{2}; \\[2ex] 1 & , & \dfrac{S+B}{2} \le n < S; \\[2ex] \sin\left[\dfrac{\pi}{2S}\left(n+\dfrac{1}{2}\right)\right] & , & S \le n < 2S. \end{cases}$$

A good set of window length parameters is L=1024, S=128, and B=32. However, other parameters instead may be used.

System Environment.

Generally speaking, except where clearly indicated otherwise, all of the systems, methods and techniques described herein can be practiced with the use of one or more programmable general-purpose computing devices. Such devices typically will include, for example, at least some of the following components interconnected with each other, e.g., via a common bus: one or more central processing units (CPUs); read-only memory (ROM); random access memory (RAM); input/output software and circuitry for interfacing with other devices (e.g., using a hardwired connection, such as a serial port, a parallel port, a USB connection or a firewire connection, or using a wireless protocol, such as Bluetooth or a 802.11 protocol); software and circuitry for connecting to one or more networks (e.g., using a hardwired connection such as an Ethernet card or a wireless protocol, such as code division multiple access (CDMA), global system for mobile communications (GSM), Bluetooth, a 802.11 protocol, or any other cellular- based or non-cellular-based system), which networks, in turn, in many embodiments of the invention, connect to the Internet or to any other networks); a display (such as a cathode ray tube display, a liquid crystal display, an organic light-emitting display, a polymeric light-emitting display or any other thin-film display); other output devices (such as one or more speakers, a headphone set and a printer); one or more input devices (such as a mouse, touchpad, tablet, touch-sensitive display or other pointing device, a keyboard, a keypad, a microphone and a scanner); a mass storage unit (such as a hard disk drive); a real-time clock; a removable storage read/write device (such as for reading from and writing to RAM, a magnetic disk, a magnetic tape, an opto-magnetic disk, an optical disk, or the like); and a modem (e.g., for sending faxes or for connecting to the Internet or to any other computer network via a dial-up connection). In operation, the process steps to implement the above methods and functionality, to the extent performed by such a general-purpose computer, typically initially are stored in mass storage (e.g., the hard disk), are downloaded into RAM and then are executed by the CPU out of RAM. However, in some cases the process steps initially are stored in RAM or ROM.

Suitable devices for use in implementing the present invention may be obtained from various vendors. In the various examples, different types of devices are used depending upon the size and complexity of the tasks. Suitable devices include mainframe computers, multiprocessor computers, workstations, personal computers, and even smaller computers such as PDAs, wireless telephones or any other appliance or device, whether stand-alone, hard-wired into a network or wirelessly connected to a network.

In addition, although general-purpose programmable devices have been described above, in alternate embodiments one or more special-purpose processors or computers instead (or in addition) are used. In general, it should be noted that, except as expressly noted otherwise, any of the functionality described above can be implemented in software, hardware, firmware or any combination of these, with the particular implementation being selected based on known engineering tradeoffs. More specifically,

where the functionality described above is implemented in a fixed, predetermined or logical manner, it can be accomplished through programming (e.g., software or firmware), an appropriate arrangement of logic components (hardware) or any combination of the two, as will be readily appreciated by those skilled in the art.

It should be understood that the present invention also relates to machine-readable media on which are stored program instructions for performing the methods and functionality of this invention. Such media include, by way of example, magnetic disks, magnetic tape, optically readable media such as CD ROMs and DVD ROMs, or semiconductor memory such as PCMCIA cards, various types of memory cards, USB memory devices, etc. In each case, the medium may take the form of a portable item such as a miniature disk drive or a small disk, diskette, cassette, cartridge, card, stick etc., or it may take the form of a relatively larger or immobile item such as a hard disk drive, ROM or RAM provided in a computer or other device.

The foregoing description primarily emphasizes electronic computers and devices. However, it should be understood that any other computing or other type of device instead may be used, such as a device utilizing any combination of electronic, optical, biological and chemical processing.

Additional Considerations.

Several different embodiments of the present invention are described above, with each such embodiment described as including certain features. However, it is intended that the features described in connection with the discussion of any single embodiment are not limited to that embodiment but may be included and/or arranged in various combinations in any of the other embodiments as well, as will be understood by those skilled in the art.

Similarly, in the discussion above, functionality sometimes is ascribed to a particular module or component. However, functionality generally may be redistributed as desired among any different modules or components, in some cases completely obviating the need for a particular component or module and/or requiring the addition of new components or modules. The precise distribution of functionality preferably is made according to known engineering tradeoffs, with reference to the specific embodiment of the invention, as will be understood by those skilled in the art.

Thus, although the present invention has been described in detail with regard to the exemplary embodiments thereof and accompanying drawings, it should be apparent to those skilled in the art that various adaptations and modifications of the present invention may be accomplished without departing from the scope of the invention. Accordingly, the invention is not limited to the precise embodiments shown in the drawings and described above. Rather, it is limited solely by the claims appended hereto.

Window Function Selection Routine.

```
if(nWinTypeFirst==WIN_SHORT_SHORT2SHORT
        || nWinTypeFirst==WIN_SHORT_SHORT2BRIEF)
{
        pnWinTypeShort[0] = WIN_SHORT_SHORT2SHORT;
        switch(nWinTypeLast)
        {
        case WIN_SHORT_BRIEF2BRIEF:
                pnWinTypeShort[0] = WIN_SHORT_BRIEF2SHORT;
                break;
        case WIN_LONG_LONG2SHORT:
        case WIN_LONG_SHORT2SHORT:
        case WIN_LONG_BRIEF2SHORT:
        case WIN_SHORT_SHORT2SHORT:
        case WIN_SHORT_BRIEF2SHORT:
                break;
        default:
                ErroHandling();
        }
}
else {
        pnWinTypeShort[0] = WIN_SHORT_BRIEF2BRIEF;
```

```
        switch (nWinTypeLast)
         {
        case WIN_SHORT_BRIEF2BRIEF:
        case WIN_SHORT_SHORT2BRIEF:
        case WIN_LONG_LONG2BRIEF:
        case WIN_LONG_BRIEF2BRIEF:
        case WIN_LONG_SHORT2BRIEF:
                break;
        default:
                ErroHandling();
        }
    }
    for (nBlock=1; nBlock<nNumBlocksPerFrm; nBlock++)
    {
            pnWinTypeShort[nBlock] = WIN_SHORT_SHORT2SHORT;
    }
    nBlock = 0;
    for (nCluster=0; nCluster<nNumCluster-1; nCluster++)
    {
            nBlock += anNumBlocksPerCluster[nCluster];
            pnWinTypeShort[nBlock] = WIN_SHORT_BRIEF2BRIEF;
    }
    if(pnWinTypeShort[0] == WIN_SHORT_BRIEF2BRIEF)
    {
            if(pnWinTypeShort[1]==WIN_SHORT_SHORT2SHORT)
             {
                    pnWinTypeShort[1] = WIN_SHORT_BRIEF2SHORT;
             }
    }
    for (nBlock=1; nBlock<nNumBlocksPerFrm-1; nBlock++)
    {
            if (pnWinTypeShort[nBlock] = WIN_SHORT_BRIEF2BRIEF)
             {
                    if(pnWinTypeShort[nBlock-1] ==
WIN_SHORT_SHORT2SHORT)
                     {
                            pnWinTypeShort[nBlock-1] =
WIN_SHORT_SHORT2BRIEF;
                     }
                    if(pnWinTypeShort[nBlock-1] ==
WIN_SHORT_BRIEF2SHORT)
                     {
                            pnWinTypeShort[nBlock-1] =
                            WIN_SHORT_BRIEF2BRIEF;
                     }
                     if(
pnWinTypeShort[nBlock+1]==WIN_SHORT_SHORT2SHORT)
                     {
                            pnWinTypeShort[nBlock+1] =
WIN_SHORT_BRIEF2SHORT;
                     }
             }
    }
    switch(pnWinTypeShort[nBlock])
     {
    case WIN_SHORT_BRIEF2BRIEF:
            if(pnWinTypeShort[nBlock-1] == WIN_SHORT_SHORT2SHORT)
             {
                    pnWinTypeShort[nBlock-1] = WIN_SHORT_SHORT2BRIEF;
             }
            if(pnWinTypeShort[nBlock-1] == WIN_SHORT_BRIEF2SHORT)
             {
                    pnWinTypeShort[nBlock-1] = WIN_SHORT_BRIEF2BRIEF;
```

```
           }
           break;
    case WIN_SHORT_SHORT2SHORT:
           if(nWinTypeFirst==WIN_SHORT_SHORT2BRIEF
                  || nWinTypeFirst==WIN_SHORT_BRIEF2BRIEF)
                  pnWinTypeShort[nBlock] = WIN_SHORT_SHORT2BRIEF;
           }
           break;
    case WIN_SHORT_BRIEF2SHORT:
           if(nWinTypeFirst==WIN_SHORT_SHORT2BRIEF
                  || nWinTypeFirst==WIN_SHORT_BRIEF2BRIEF)
           {
                  pnWinTypeShort[nBlock] = WIN_SHORT_BRIEF2BRIEF;
           }
           break;
     default:
           ErroHandling();
     }
```

where:

| Variable | Explanation |
|---|---|
| nWinTypeFirst | Indicates if there is transient in the first block of the current frame and in the first block of the next frame. |
| nWinTypeLast | Window function for the last block in the last Frame. |
| pnWinTypeShort[nBlock] | Window function for the nBlock-th block. |
| nNumBlocksPerFrm | Number of blocks in a frame. |
| nNumCluster | Number of transient clusters in a frame. A transient cluster starts with a transient and ends before the start of the next transient or the end of the frame. |
| anNumBlocksPerCluster[nCluster] | Number of blocks in the nCluster-th cluster whose first block contains the transient. |
| ErroHandling() | Any error handling function defined by user. |

**Claims**

1.  A method of processing frame-based data, comprising:

    (a) obtaining (202) a frame of data comprising an audio signal, an indication that a transient occurs within the frame (203), and a location of the transient within the frame;
    (b) setting (210) a first block size for the frame based on the indication of the transient, thereby effectively defining a plurality of first blocks within the frame having the transient;
    (c) setting a second block size covering the entire frame by a single second block within frames not including a transient, wherein that single second block overlaps with an adjacent one of the first blocks from the frame having the transient;
    (d) selecting the window function (130 - 170) for the second block and applying that window function to the frame not having the transient;
    (e) selecting (212) different window functions (40, 100 - 120) for different ones of the plurality of equal-sized blocks based on the location of the transient; and
    (f) processing (19) the frames of data having the transient and not having the transient by applying (17) the window functions (100 - 170) as selected in steps (d) and (e), wherein the window function selection in (e) includes:

        a standard window function (40) for the frame having the transient, and
        at least one of (i) a pre-transient transition window function (110) and (ii) a post-transient transition window function (120); wherein

the pre-transient transition window function (110), if any, is used within the frame having the transient in the block that immediately precedes the block that includes the transient; and

the post-transient transition window function (120), if any, is used within the frame having the transient in the block that immediately follows the block that includes the transient;

**characterized in that**

the first block size is set for all of the plurality of first blocks within the frame having the transient, making all first blocks within the frame having the transient equal-sized contiguous blocks that are uniformly distributed throughout the frame having the transient and overlap each other; and

the window functions (100 - 120) for the first blocks are selected to provide higher temporal resolution within an identified one of the equal-sized blocks that includes the transient, the higher temporal resolution being provided by using, within the identified block, a transient window function (100) that is narrower than others of the window functions and by zeroing samples outside of the transient window function.

2. A method according to claim 1, wherein the window functions (40, 100 - 170) overlap each other in a manner so as to satisfy perfect reconstruction conditions.

3. A method according to claim 1, further comprising a step of repeating steps (a)-(f) a plurality of times for different frames of data.

4. A system for processing frame-based data, comprising:

(a) means for obtaining (202) a frame of data comprising an audio signal, an indication (203) that a transient occurs within the frame, and a location of the transient within the frame;

(b) means for setting (210) a first block size for the frame based on the indication of the transient, thereby effectively defining a plurality of first blocks within the frame having the transient;

(c) means for setting a second block size covering the entire frame by a single second block within frames not including a transient, wherein that single second block overlaps with an adjacent one of the first blocks from the frame having the transient;

(d) means for selecting the window function (130 - 170) for the second block and applying that window function to the frame not having the transient;

(e) means for selecting (212) different window functions (40, 100 - 120) for different ones of the plurality of equal-sized blocks based on the location of the transient; and

(f) means for processing (19) the frames of data having the transient and not having the transient by applying (17) the window functions as selected by said means (d) and (e), wherein the means in (e) are configured to select the window functions including:

a standard window function (40) for the frame having the transient, and

at least one of (i) a pre-transient transition window function (110) and (ii) a post-transient transition window function (120); wherein

the pre-transient transition window function (110), if any, is used within the frame having the transient in the block that immediately precedes the block that includes the transient; and

the post-transient transition window function (120), if any, is used within the frame having the transient in the block that immediately follows the block that includes the transient;

**characterized in that**

the means in (b) for setting (210) the first block size of the first blocks within the frame having the transient are configured to set the first block size for all of the plurality of first blocks within the frame having the transient, making all first blocks equal-sized contiguous blocks that are uniformly distributed throughout the frame having the transient and overlap each other; and

the means in (e) for selecting window functions (100 - 120) are configured to select the window functions to provide higher temporal resolution within an identified one of the equal-sized blocks that includes the transient, the higher temporal resolution being provided by using, within the identified block, a transient window function (100) that is narrower than others of the window functions and by zeroing samples outside of the transient window function.

5. A system according to claim 4, the window functions (40, 100 - 170) selected by the means for selecting (212) overlap each other in a manner so as to satisfy perfect reconstruction conditions.

**6.** A system according to claim 4, further comprising means for repeating instantiation of said means (a)-(f) a plurality of times for different frames of data.

**Patentansprüche**

**1.** Ein Datenverarbeitungsverfahren zum Verarbeiten von in Datenrahmen gefasste Daten, mit:

(a) Empfangen (202) von einem Datenrahmen, welcher ein Audiosignal enthält, sowie eine Information, dass sich in dem Datenrahmen eine Transiente befindet, und wo sich diese Transiente innerhalb des Datenrahmens befindet;

(b) Festlegen (210) einer ersten Blockgröße für den Datenrahmen aufgrund der Information, dass eine Transiente vorliegt, wodurch eine Mehrzahl von ersten Blöcken innerhalb des Datenrahmens festgelegt werden, welcher die Transiente aufweist;

(c) Festlegen einer zweiten Blockgröße, welche den gesamten Datenrahmen durch einen einzigen zweiten Block innerhalb derjenigen Datenrahmen ausfüllt, welche keine Transiente aufweisen, wobei der einzelne zweite Block sich mit einem benachbarten ersten Block von einem Datenrahmen überlappt, welcher die Transiente aufweist;

(d) Auswählen einer Fensterfunktion (130-170) für den zweiten Block und Anwenden dieser Fensterfunktion auf den Datenrahmen, welcher keine Transiente aufweist;

(e) Auswählen (212) einer unterschiedlichen Fensterfunktionen (40,100-120) für andere Blöcke gleicher Größe basierend auf dem Ort der Transiente; und

(f) Verarbeiten (19) der Datenrahmen, welche eine Transiente aufweisen und welche keine Transiente aufweisen durch Anwenden (17) der Fensterfunktionen (100-170), wie diese in den Schritten (d) und (e) ausgewählt wurden, wobei die in (e) ausgewählten Fensterfunktionen die folgenden Fensterfunktionen aufweisen:

eine Standard-Fensterfunktion (40) für den Datenrahmen, welcher die Transiente aufweist, und eine (i) Vor-Transienten-Übergangs-Fensterfunktion (110) und/oder eine (ii) Nach-Transienten-Übergangs-Fensterfunktion (120); wobei

die Vor-Transienten-Übergangs-Fensterfunktion (110), sofern vorhanden, in dem Datenrahmen in dem die Transiente aufweisenden Block unmittelbar vorangehenden Block verwendet wird;

die Nach-Transienten-Übergangs-Fensterfunktion (120), sofern vorhanden, in dem Datenrahmen in dem die Transiente aufweisenden Block unmittelbar nachgeschalteten Block verwendet wird;

**dadurch gekennzeichnet, dass**

die gleiche erste Blockgröße für alle Blöcke der Mehrzahl von ersten Blöcken innerhalb des die Transiente aufweisenden Datenrahmens festgelegt wird, wodurch alle ersten Blöcke innerhalb des die Transiente aufweisenden Datenrahmens identische Größe haben und in Reihe hintereinandergeschaltete Blöcke sind, welche gleichmäßig über den die Transiente aufweisenden Datenrahmen verteilt sind und einander überlappen; und

die Fensterfunktionen (100-120) für die ersten Blöcke für eine höhere zeitliche Auflösung innerhalb eines die Transiente aufweisenden identifizierten Blocks der Blöcke gleicher Größe ausgewählt wird, wobei die höhere zeitliche Auflösung durch Anwenden einer Transienten-Fensterfunktion (100) innerhalb des identifizierten, die Transiente aufweisenden Blocks erzielt wird, wobei die Transienten-Fensterfunktion schmäler als die anderen Fensterfunktionen ist, und durch Nullsetzen außerhalb der Transienten-Fensterfunktion erzielt wird.

**2.** Ein Verfahren nach Anspruch 1, wobei die Fensterfunktionen (40,100-170) einander derart überlappen, dass diese perfekte Rekonstruktionsbedingungen erfüllen.

**3.** Ein Verfahren nach Anspruch 1, weiter versehen mit mehrfacher Wiederholung der Schritte (a)-(f) für unterschiedliche Datenrahmen.

**4.** Ein Datenverarbeitungssystem zum Verarbeiten von in Datenrahmen gefasste Daten, mit:

(a) einer Einrichtung zum Empfangen (202) von einem Datenrahmen, welcher ein Audiosignal enthält, sowie eine Information, dass sich in dem Datenrahmen eine Transiente befindet, und wo sich diese Transiente innerhalb des Datenrahmens befindet;

(b) einer Einrichtung zum Festlegen (210) einer ersten Blockgröße für den Datenrahmen aufgrund der Information, dass eine Transiente vorliegt, wodurch eine Mehrzahl von ersten Blöcken innerhalb des Datenrahmens festgelegt werden, welcher die Transiente aufweist;

(c) einer Einrichtung zum Festlegen einer zweiten Blockgröße, welche den gesamten Datenrahmen durch einen einzigen zweiten Block innerhalb derjenigen Datenrahmen ausfüllt, welche keine Transiente aufweisen, wobei der einzelne zweite Block sich mit einem benachbarten ersten Block von einem Datenrahmen überlappt, welcher die Transiente aufweist;

(d) einer Einrichtung zum Auswählen einer Fensterfunktion (130-170) für den zweiten Block und Anwenden dieser Fensterfunktion auf den Datenrahmen, welcher keine Transiente aufweist;

(e) einer Einrichtung zum Auswählen (212) von unterschiedlichen Fensterfunktionen (40,100-120) für andere Blöcke gleicher Größe basierend auf dem Ort der Transiente; und

(f) einer Einrichtung zum Verarbeiten (19) der Datenrahmen, welche eine Transiente aufweisen und welche keine Transiente aufweisen durch Anwenden (17) der Fensterfunktionen (100-170), wie diese durch die Einrichtungen (d) und (e) ausgewählt wurden, wobei die durch die Einrichtung (e) ausgewählten Fensterfunktionen die folgenden Fensterfunktionen aufweisen:

eine Standard-Fensterfunktion (40) für den Datenrahmen, welcher die Transiente aufweist, und
eine (i) Vor-Transienten-Übergangs-Fensterfunktion (110) und/oder eine (ii) Nach-Transienten-Übergangs-Fensterfunktion (120); wobei
die Vor-Transienten-Übergangs-Fensterfunktion (110), sofern vorhanden, in dem Datenrahmen in dem die Transiente aufweisenden Block unmittelbar vorangehenden Block verwendet wird;
die Nach-Transienten-Übergangs-Fensterfunktion (120), sofern vorhanden, in dem Datenrahmen in dem die Transiente aufweisenden Block unmittelbar nachgeschalteten Block verwendet wird;
**dadurch gekennzeichnet, dass**
die Einrichtung (b) zum Festlegen der ersten gleichen Blockgröße für alle Blöcke der Mehrzahl von ersten Blöcken innerhalb des die Transiente aufweisenden Datenrahmens konfiguriert ist, wodurch alle ersten Blöcke innerhalb des die Transiente aufweisenden Datenrahmens identische Größe haben und in Reihe hintereinandergeschaltete Blöcke sind, welche gleichmäßig über den die Transiente aufweisenden Datenrahmen verteilt sind und einander überlappen; und
die Einrichtung (e) zum Auswählen der Fensterfunktionen (100-120) für die ersten Blöcke für eine höhere zeitliche Auflösung innerhalb eines die Transiente aufweisenden identifizierten Blocks der Blöcke gleicher Größe konfiguriert ist, wobei die höhere zeitliche Auflösung durch Anwenden einer Transienten-Fensterfunktion (100) innerhalb des identifizierten, die Transiente aufweisenden Blocks erzielt wird, wobei die Transienten-Fensterfunktion schmäler als die anderen Fensterfunktionen ist, und durch Nullsetzen außerhalb der Transienten-Fensterfunktion erzielt wird.

5. Ein System nach Anspruch 4, wobei die von der Einrichtung zum Auswählen (212) ausgewählten Fensterfunktionen (40,100-170) einander derart überlappen, dass diese perfekte Rekonstruktionsbedingungen erfüllen.

6. Ein System nach Anspruch 4, weiter versehen mit einer Einrichtung zum Auslösen einer mehrfachen Wiederholung der Aktivierung der Einrichtungen (a)-(f) für unterschiedliche Datenrahmen.

**Revendications**

1. Procédé de traitement de données basées sur une trame, consistant à :

(a) obtenir (202) une trame de données comprenant un signal audio, une indication qu'un phénomène transitoire se produit au sein de la trame (203), et un emplacement du phénomène transitoire au sein de la trame ;
(b) paramétrer (210) une première taille de bloc pour la trame sur la base de l'indication du phénomène transitoire, ce qui permet de définir efficacement une pluralité de premiers blocs au sein de la trame ayant le phénomène transitoire ;
(c) paramétrer une seconde taille de bloc couvrant l'intégralité de la trame par un seul second bloc au sein de trames ne comprenant pas de phénomène transitoire, ce seul second bloc chevauchant un bloc adjacent des premiers blocs présents dans la trame ayant le phénomène transitoire ;
(d) sélectionner la fonction de fenêtrage (130 à 170) pour le second bloc et appliquer cette fonction de fenêtrage à la trame n'ayant pas le phénomène transitoire ;
(e) sélectionner (212) différentes fonctions de fenêtrage (40, 100 à 120) pour des blocs différents de la pluralité de blocs de même taille sur la base de l'emplacement du phénomène transitoire ; et

(f) traiter (19) les trames de données ayant le phénomène transitoire et n'ayant pas le phénomène transitoire en appliquant (17) les fonctions de fenêtrage (100 à 170) sélectionnées aux étapes (d) et (e), la sélection des fonctions de fenêtrage en (e) comprenant :

une fonction de fenêtrage standard (40) pour la trame ayant le phénomène transitoire, et
au moins une parmi (i) une fonction de fenêtrage de transition pré-phénomène transitoire (110) et (ii) une fonction de fenêtrage de transition post-phénomène transitoire (120) ;
la fonction de fenêtrage de transition pré-phénomène transitoire (110), le cas échéant, étant utilisée au sein de la trame ayant le phénomène transitoire dans le bloc précédant immédiatement le bloc qui comprend le phénomène transitoire ; et
la fonction de fenêtrage de transition post-phénomène transitoire (120), le cas échéant, étant utilisée au sein de la trame ayant le phénomène transitoire dans le bloc qui suit immédiatement le bloc qui comprend le phénomène transitoire ;
**caractérisé en ce que**
la première taille de bloc est paramétrée pour tous les blocs de la pluralité de blocs au sein de la trame ayant le phénomène transitoire, amenant tous les premiers blocs au sein de la trame ayant le phénomène transitoire à être des blocs contigus de même taille qui sont répartis uniformément dans la trame ayant le phénomène transitoire et à se chevaucher les uns les autres ; et
les fonctions de fenêtrage (100 à 120) pour les premiers blocs sont sélectionnées pour permettre une résolution temporelle supérieure au sein d'un bloc identifié des blocs de même taille qui comprend le phénomène transitoire, la résolution temporelle supérieure étant assurée par l'utilisation, au sein du bloc identifié, d'une fonction de fenêtrage de phénomène transitoire (100) qui est plus étroite que d'autres des fonctions de fenêtrage et le passage par zéro des échantillons hors de la fonction de fenêtrage de phénomène transitoire.

2.  Procédé selon la revendication 1, dans lequel les fonctions de fenêtrage (40, 100 à 170) se chevauchent les unes les autres de manière à satisfaire à des conditions de reconstruction parfaite.

3.  Procédé selon la revendication 1, comprenant en outre une étape de répétition des étapes (a) à (f) une pluralité de fois pour différentes trames de données.

4.  Système de traitement de données basées sur une trame, comportant :

(a) des moyens pour obtenir (202) une trame de données comprenant un signal audio, une indication (203) qu'un phénomène transitoire se produit au sein de la trame, et un emplacement du phénomène transitoire au sein de la trame ;
(b) des moyens pour paramétrer (210) une première taille de bloc pour la trame sur la base de l'indication du phénomène transitoire, ce qui permet de définir efficacement une pluralité de premiers blocs au sein de la trame ayant le phénomène transitoire ;
(c) des moyens pour paramétrer une seconde taille de bloc couvrant l'intégralité de la trame par un seul second bloc au sein de trames ne comprenant pas de phénomène transitoire, ce seul second bloc chevauchant un bloc adjacent des premiers blocs à partir de la trame ayant le phénomène transitoire ;
(d) des moyens pour sélectionner la fonction de fenêtrage (130 à 170) pour le second bloc et pour appliquer cette fonction de fenêtrage à la trame n'ayant pas le phénomène transitoire ;
(e) des moyens pour sélectionner (212) différentes fonctions de fenêtrage (40, 100 à 120) pour des blocs différents de la pluralité de blocs de même taille sur la base de l'emplacement du phénomène transitoire ; et
(f) des moyens pour traiter (19) les trames de données ayant le phénomène transitoire et n'ayant pas le phénomène transitoire en appliquant (17) les fonctions de fenêtrage sélectionnées par lesdits moyens (d) et (e), les moyens en (e) étant conçus pour sélectionner les fonctions de fenêtrage comprenant :

une fonction de fenêtrage standard (40) pour la trame ayant le phénomène transitoire, et
au moins une parmi (i) une fonction de fenêtrage de transition pré-phénomène transitoire (110) et (ii) une fonction de fenêtrage de transition post-phénomène transitoire (120) ;
la fonction de fenêtrage de transition pré-phénomène transitoire (110), le cas échéant, étant utilisée dans la trame ayant le phénomène transitoire dans le bloc précédant immédiatement le bloc qui comprend le phénomène transitoire ; et
la fonction de fenêtrage de transition post-phénomène transitoire (120), le cas échéant, étant utilisée au sein de la trame ayant le phénomène transitoire dans le bloc qui suit immédiatement le bloc qui comprend le phénomène transitoire ;

**caractérisé en ce que**

les moyens en (b) pour paramétrer (210) la première taille de bloc des premiers blocs au sein de la trame ayant le phénomène transitoire sont conçus pour paramétrer la première taille de bloc pour tous les blocs de la pluralité de premiers blocs au sein de la trame ayant le phénomène transitoire, amenant tous les premiers blocs à être des blocs contigus de même taille qui sont répartis uniformément dans la trame ayant le phénomène transitoire et à se chevaucher les uns les autres ; et

les moyens en (e) pour sélectionner les fonctions de fenêtrage (100 à 120) sont conçus pour sélectionner les fonctions de fenêtrage pour permettre une résolution temporelle supérieure au sein d'un bloc identifié des blocs de même taille qui comprend le phénomène transitoire, la résolution temporelle supérieure étant assurée par l'utilisation, au sein du bloc identifié, d'une fonction de fenêtrage de phénomène transitoire (100) qui est plus étroite que d'autres des fonctions de fenêtrage et en passant par zéro des échantillons hors de la fonction de fenêtrage de phénomène transitoire.

5. Système selon la revendication 4, les fonctions de fenêtrage (40, 100 à 170) sélectionnées par les moyens de sélection (212) se chevauchent les unes les autres de manière à satisfaire à des conditions de reconstruction parfaite.

6. Système selon la revendication 4, comprenant en outre des moyens pour répéter l'instanciation desdits moyens (a) à (f) une pluralité de fois pour différentes trames de données.

**FIG. 1**
(Prior Art)

WIN_LONG_LONG2LONG

**FIG. 2**
(Prior Art)

WIN_SHORT_SHORT2SHORT

**FIG. 3**
(Prior Art)

WIN_LONG_LONG2SHORT

**FIG. 4**
(Prior Art)

WIN_LONG_SHORT2LONG

**FIG. 5**
(Prior Art)

WIN_LONG_SHORT2SHORT

**FIG. 6**
(Prior Art)

**FIG. 7**
(Prior Art)

WIN_SHORT_BRIEF2BRIEF

102 103

**FIG. 8**

WIN_SHORT_SHORT2BRIEF

102 103

**FIG. 9**

WIN_SHORT_BRIEF2SHORT

102 103

**FIG. 10**

WIN_LONG_LONG2BRIEF

130

**FIG. 11**

WIN_LONG_BRIEF2LONG

140

**FIG. 12**

WIN_LONG_BRIEF2BRIEF

150

**FIG. 13**

WIN_LONG_SHORT2BRIEF

160

**FIG. 14**

WIN_LONG_BRIEF2SHORT

170

**FIG. 15**

START

OBTAIN DATA FRAME AND
TRANSIENT INDICATOR — 202

TRANSIENT PRESENT? — 203

NO

YES

SET BLOCK SIZE — 205

210 — SET BLOCK SIZE

SELECT WINDOW
FUNCTION(S) — 207

212 — SELECT DIFFERENT
WINDOW FUNCTIONS

— 216

APPLY WINDOW FUNCTION(S) — 17

**FIG. 16**

— 100

— 30 — 130 — 120 — 40 — 60 — 30

**FIG. 17**

**FIG. 18**

**FIG. 19**

**FIG. 20**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 60822760 B
- US 5214742 A
- US 6226608 B1
- WO 2006030289 A1
- US 2003115052 A1

**Non-patent literature cited in the description**

- **H. S. MALVAR.** Signal Processing with Lapped Transforms. *Artech House,* 1992